Europäisches Patentamt

**European Patent Office**

Office européen des brevets

(19)

(11) Publication number: **0 194 205**
**B1**

# EUROPEAN PATENT SPECIFICATION

(12)

(45) Date of publication of the patent specification:
24.10.90

(21) Application number: **86400480.9**

(22) Date of filing: **07.03.86**

(51) Int. Cl.⁵: **H01L 21/90, H01L 23/52**

(54) A method for fabricating A 1-chip microcomputer.

(30) Priority: **08.03.85 JP 45808/85**

(43) Date of publication of application:
**10.09.86 Bulletin 86/37**

(45) Publication of the grant of the patent:
**24.10.90 Bulletin 90/43**

(84) Designated Contracting States:
**DE FR GB**

(56) References cited:
**EP-A- 0 127 100**

**PATENT ABSTRACTS OF JAPAN, vol. 9,
no. 240 (E-345)[1963], 26th September 1985; &
JP-A-60 89 955 (MITSUBISHI DENKI K.K.) 20-05-1985**

(73) Proprietor: **FUJITSU LIMITED, 1015, Kamikodanaka
Nakahara-ku, Kawasaki-shi Kanagawa 211(JP)**

(72) Inventor: **Takahashi, Hitoshi
Iwanaridainishi-danchi 610-502, 4-1, Iwanaridai 8 chome,
Kasugai-shi Aichi 487(JP)**

(74) Representative: **Descourtieux, Philippe et al, CABINET
BEAU de LOMENIE 55 rue d'Amsterdam,
F-75008 Paris(FR)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

The present invention relates to the fabrication of a 1-chip microcomputer, in particular, to the fabrication of a chip referred to as an evaluation chip which is used for evaluating a program built in a 1-chip microcomputer to be mass-produced.

Microcomputers have been used for controlling the operations of various industrial equipment and consumer applicances. Generally, the microcomputer used for these applications is a 1-chip microcomputer in which facilities including logic circuits and memory devices are integrated on a semiconductor chip. Such a 1-chip microcomputer comprises a ROM (Read Only Memory) for storing a program under which the operation of the microcomputer is controlled. The program is developed according to the functions provided for the equipment and so forth; therefore, it is different with each user of the 1-chip microcomputer. Unless an EPROM (Erasable Programmable ROM) is employed for a 1-chip microcomputer, the program must be completely debugged and subjected to functional tests in advance, since it cannot be modified once written in the ROM.

It is necessary that the functional tests must be performed in a comprehensive system environment including the 1-chipmicrocomputer and the equipment and so forth. Therefore, an evaluation chip is prepared in advance. The evaluation chip is usually fabricated based on the design resources of a 1-chip microcomputer to be mass-produced, wherein an external memory device is used to substitute for the ROM for storing the program. Thus, the program can be subjected to modifications as many times as required according to the results of the functional tests. To have an access to the external memory device, the evaluation chip is provided with an interface circuit including address output buffer and data input buffer. The configuration of a conventional evaluation chip will be explained in the following in comparison with that of a chip of the corresponding 1-chip microcomputer to be mass-produced.

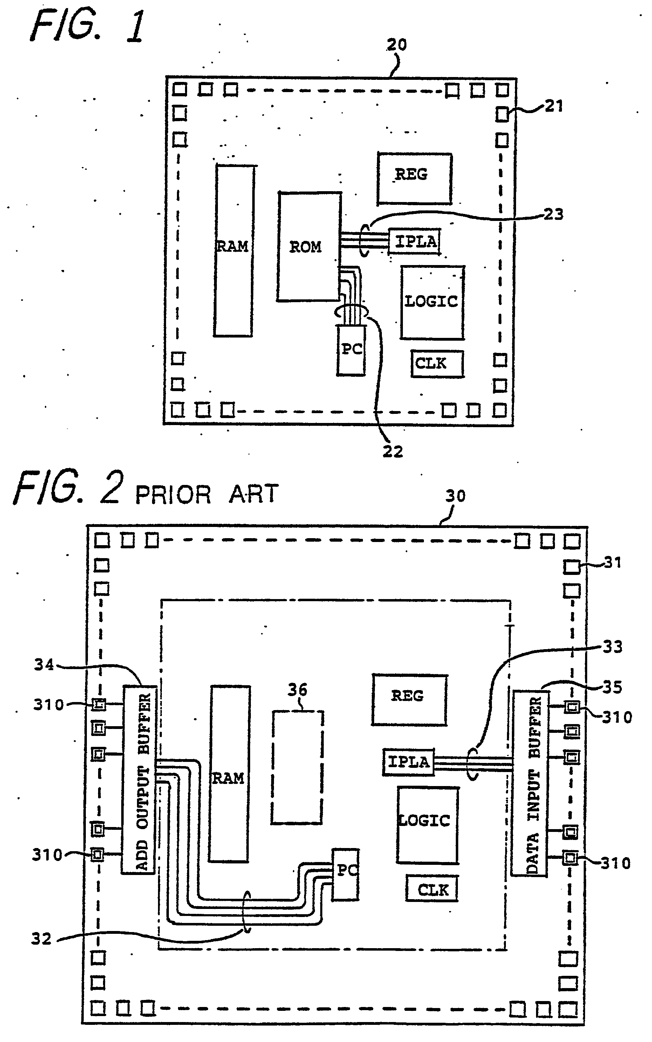

Fig. 1 is a schematic plan view of an exemplary arrangement of facilities formed in a chip 20 of a 1-chip microcomputer, the facilities including a RAM (Random Access Memory), registers REG, logic circuits LOGIC, a clock generator CLK, an instruction programmable logic array IPLA, a program counter PC and a ROM. When receiving an address signal from PC, ROM outputs a corresponding data or an instruction stored therein to IPLA. In Fig. 1, these facilities are represented as the respective regions allotted for them on the chip 20 and it will be done so in the following drawings. Also in Fig. 1, only connections 22 and 23 relevant to the respective transmissions of the address and data signals are illustrated. Generally, the data consists of parallel eight bits, but the number of the address bits differs depending on the capacity of the ROM; 10 bits for a ROM of 1K bits, for instance. Further, a number of bonding pads 21, which are referred to as first bonding pads hereinafter, are formed at the periphery of the chip 20. The first bonding pads 21 are usually arranged in an array surrounding the facilities. Each of the first bonding pads 21 is connected to one of the facilities with a corresponding wiring (not shown). The first bonding pads 21 are disposed with a constant pitch due to the general requirement of automatic bonding machines.

Fig. 2 is a schematic plan view of an exemplary configuration of a conventional evaluation chip for the 1-chip microcomputer shown in Fig. 1. Referring to Fig.2, the evaluation chip 30 has an extended area around an inner area indicated by a dot-dash line. The inner area is referred to as a device area hereinafter, in which the same facilities as in the 1-chip microcomputer of Fig. 1, except for the ROM, are formed. The arrangement of these facilities in the device area is substantially the same as in the 1-chip microcomputer shown in Fig. 1. The bonding pads 31 corresponding to the first bonding pads 21 in Fig.1 are formed in the extended area instead of the device area and connected to the facilities via wirings not shown. In the evaluation chip 30, the region 36 allotted for the ROM of the 1-chip microcomputer is blank, and an address output buffer 34 and a data input buffer 35 are provided in the extended area of the chip 30 instead. The region 36 is referred to as a ROM region hereinafter. The address output buffer 34 and data input buffer 35 are connected to PC and IPLA, respectively, via respective wirings 32 and 33 and allow the evaluation chip to have an access to an external memory device for storing the program to be evaluated.

Thus, the masks for fabricating the evaluation chip can be produced based on the existing masks prepared for the mass-production chips of the 1-chip microcomputer, said existing masks being modified by adding patterns necessary for forming the buffers 34 and 35 and the wirings 32 and 33, and by changing the arrangement of the bonding pads 31 and the connections between the bonding pads 31 and the facilities in the device region.

It is necessary that the operations of the facilities in the evaluation chip be confirmed prior to the evaluation of the program. This requirement is satisfied in an evaluation chip of a 1-chip microcomputer which has already been used in the field. However, when a 1-chip microcomputer is newly developed, either one of a preliminary mass-production chip or an evaluation chip is fabricated for the purpose of carrying out said confirmation in advance. In other words, if a chip has already been fabricated, the development of another one can be carried out based on the design resources of the previous one.

Referring back to Fig. 1, since ROM has no external connections, there are no spare bonding pads with the omission of ROM in the evaluation chip 30. As a result, in Fig. 2, the bonding pads 31 include incremental pads 310 for connecting the buffers 34 and 35 to the aforesaid external memory device (not shown). The total number of the incremental bonding pads 310 amounts to 18, for instance. To facilitate the accommodation of the additional patterns of the incremental bonding pads and of the address output and data input buffers, the evaluation chip 30 is generally designed to have an extended area compared with the mass-production chip of Fig.1.

As described before, the facilities formed in the device area are arranged and interconnected with each other substantially as in the 1-chip microcomputer shown in Fig. 1. However, the pads 31 and 310 must be disposed with a constant pitch because of the above mentioned reason. Therefore, when the total number of bonding pads 31 is increased due to the incremental pads 310, the relative arrangement of the pads 31 with respect to the facilities cannot remain as in the 1-chip microcomputer. This means that the modification in the masks for fabricating the conventional evaluation chip is not limited to the addition of the buffers 34 and 35 together with the incremental bonding pads 310 and wirings 32 and 33 but involves a comprehensive redesign in the wiring pattern for connecting the bonding pads 31 to the facilities.

Such a redesign for a number of complicated wirings inevitably requires a time consuming procedure and may cause erroneous connections which make not only the evaluation chip but the wiring masks useless. Moreover, the conventional evaluation chip must be designed to have a margin for the chip area thereof so as to permit the wirings 32 and 33 to be distributed without intersecting the existing wirings. When the margin is already provided in the mass-production chips, the chip area utilization efficiency is decreased. On the other hand, when the layout in the mass-production chip is optimized and the margin must be afforded in the evaluation chip, the aforesaid redesign in the wiring pattern inevitably becomes further complicated.

It is, therefore, an object of the present invention to provide an efficent fabrication method for an evaluation chip of a 1-chip microcomputer.

It is another object of the present invention to provide a reliable designing method for an evaluation chip.

More specifically, it is yet another object of the present invention to provide a fabrication method for an evaluation chip of a 1-chip microcomputer, the method allowing a simplification of the distribution of wirings on the evaluation chip and an elimination of erroneous connections in the wirings, and enhancing the chip area utilization efficiency.

The above objects can be achieved by a method for fabricating a 1-chip microcomputer comprising the steps of:

(a) producing a first set of masks which are used for mass-producing chips of the 1-chip microcomputer, each of the masks having regions in which patterns for forming pluralities of first bonding pads, a ROM and other facilities are provided, the first bonding pads being arranged in an array surrounding the other facilities;

(b) fabricating a chip of the 1-chip microcomputer by using the first set masks;

(c) producing a second set of masks for an evaluation chip, said evaluation chip being used for evaluating a program to be held in the ROM of each mass-production chip, said production of the second set of masks comprising the steps of:

- replacing the patterns for the ROM region in each of the first set of masks by corresponding patterns for forming interface means for allowing the evaluation chip to have an access to an external memory device; and
- adding to the first set of masks patterns for forming second bonding pads and connection wirings between the second bonding pads and the first bonding pads and the interface means, the second bonding pads being arranged in an array surrounding the array of the first bonding pads; and

(d) fabricating an evaluation chip by using the second set of masks.

These and other objects and advantages of the present invention will be apparent from a reading of the following description made with reference to the accompanying drawings wherein:

Fig. 1 is a schematic plan view of an exemplary arrangement of patterns formed in a chip of a 1-chip microcomputer;

Fig. 2 is a schematic plan view illustrating an exemplary arrangement of patterns formed on a conventional evaluation chip for the 1-chip microcomputer as shown in Fig. 1;

Fig. 3 is a schematic plan view of an exemplary arrangement of patterns formed on an evaluation chip in accordance with a first embodiment of the present invention;

Fig. 4 is a schematic plan view illustrating an exemplary arrangement of patterns formed on an evaluation chip in accordance with a second embodiment of the present invention;

Fig. 5 is a schematic plan view illustrating a further detailed arrangement of patterns formed on an evaluation chip in accordance with a third embodiment of the present invention;

Figs. 6A and 6B are a schematic partial plan view and cross-section of an evaluation chip fabricated according to the second or third embodiment, illustrating the first and second bonding pads and an interconnection therebetween; and

Figs. 7A and 7B are a schematic partial plan view and cross-section of an evaluation chip fabricated according to the second or third embodiment, illustrating a second bonding pad and an interconnection between a buffer circuit and the second bonding pad.

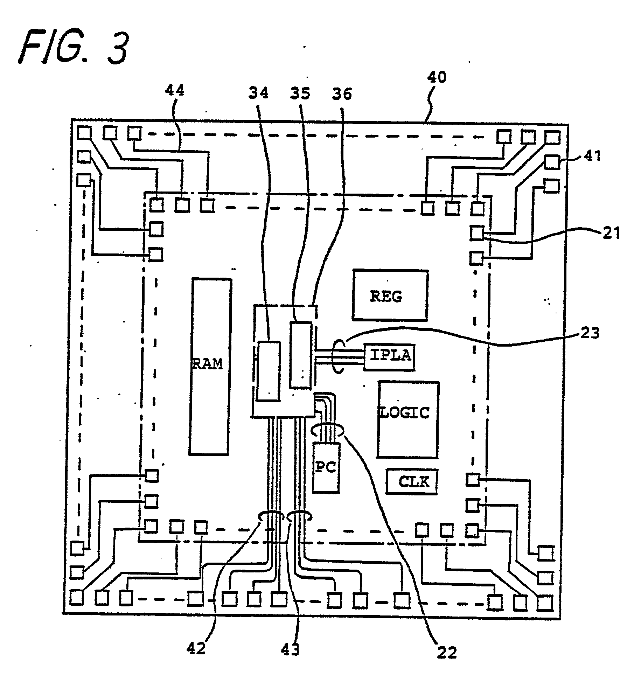

Fig. 3 is a schematic plan view of an exemplary arrangement of patterns formed on an evaluation chip in accordance with a first embodiment of the present invention. Referring to Fig. 3, chip 40 of a semiconductor substrate has facilities including a RAM, registers REG, logic circuits LOGIC, a clock generator CLK, an instruction programmable logic array IPLA, and a program counter PC, all the same as in a corresponding 1-chip microcomputer, except for a ROM to be formed in the region 36. These facilities are arranged in a device area, which is enclosed by a virtual dot-dash line, and interconnected with each other by means of wirings not shown, except wirings 22 and 23. Some of the facilities are connected to first bonding pads 21 formed at the periphery of the device area by means of wirings (not shown). The pattern of the interconnections between the facilities and the respective connections between the same facilities and the first bonding pads 21 are quite the same as in the corresponding 1-chip microcomputer shown in Fig. 1. The chip 40 is provided with an extended area around the device area.

Different from the prior art arrangement shown in Fig. 2, the aforesaid address output buffer 34 and data input buffer 35 are formed in the ROM region 36. The inputs of the address output buffer 34 are connected to the program counter PC by means of wirings (a bus line) 22 and the outputs of the data input buffer 35 are connected to the instruction programmable logic array IPLA by means of wirings (a bus line) 23. The wirings 22 and 23 are formed quite the same as in the 1-chip microcomputer of Fig. 1. At the periphery of the extended area, there are provided second bonding pads 41 which are formed in a number larger than that of the first bonding pads 21 by the number necessary for the connections to the wirings 22 and 23. The second bonding pads 41 are disposed with a substantially constant pitch so as to comply with the requirement of automatic bonding machines. Most of the second bonding pads 41 are connected to the first pads 21, preferably to the respective nearest ones, by means of corresponding wirings 44 and the remaining second bonding pads are connected to the outputs of the address output buffer 34 and to the inputs of the data input buffer 35 by means of respective wirings (bus lines) 42 and 43. Thus, the first bonding pads 21 and the corresponding second bonding pads 41 can be interconnected by relatively short and simple wirings 44.

With the configuration shown in Fig. 3, patterns for the facilities and wirings in a 1-chip microcomputer can be used for producing masks for the corresponding evaluation chip, except for the ROM region. In other words, the evaluation chip can be designed only by replacing the ROM pattern in each of the masks for the 1-chip microcomputer by respective patterns for forming address output and data input buffers, and by adding patterns for providing the second bonding pads and wirings connecting the second bonding pads to the buffers and the first bonding pads. Accordingly, the fabrication of an evaluation chip can be facilitated and shows an enhanced reliability compared with the prior art method explained with reference to Fig. 2. Further, the present invention allows an efficient use of the chip area because the address output and data input buffers are formed in the ROM region 36 which is not utilized in the conventional evaluation chip shown in Fig. 2, and the extended area around the device area can be as small as possible, so far as it can accommodate the second bonding pads and the wirings connected thereto.

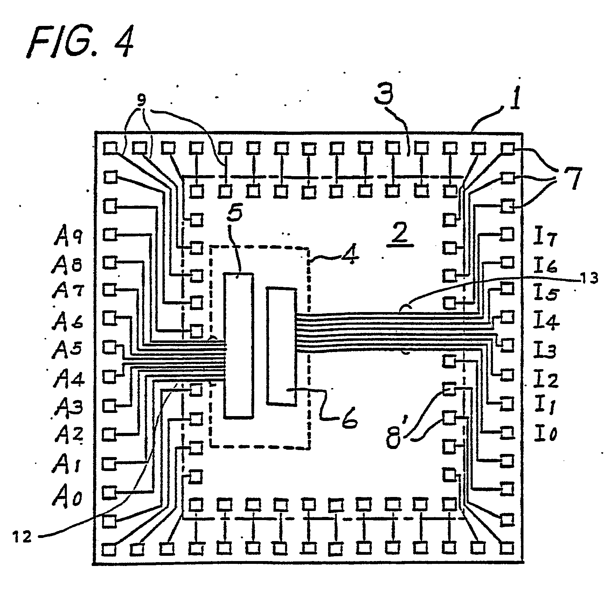

Fig. 4 is a schematic plan view illustrating an exemplary arrangement of patterns formed on an evaluation chip in accordance with a second embodiment of the present invention, wherein a multiple-layer wiring technology is employed for the aforesaid second bonding pads and wirings connected thereto. In Fig. 4, only an address output buffer 5 and data input buffer 6 both formed in a region 4 on an evaluation chip 1 are shown and other facilities are omitted from the illustration. The region 4 is allotted for the ROM in the corresponding mass-production chip. The address output and data input buffers 5 and 6 are connected to respective groups of second bonding pads 7, a first group consisting of $A_0$ to $A_9$ and a second group $I_0$ to $I_7$, by wirings 12 and 13, respectively. The wirings for interconnecting the not shown facilities and first bonding pads 8' in a device area 2 enclosed by a dot-dash line are formed exactly as in the corresponding mass-production chip. Each of the first bonding pads 8' is connected to a respective one of the second bonding pads 7 by a corresponding wiring 9.

The use of a multiple-layer wiring configuration eliminates the need for the aforesaid area margin for distributing the wirings 12 and 13 in the device area, which margin might still be required in the embodiment of Fig. 3. Accordingly, the arrangement of the facilities and the pattern of wirings in the evaluation chip 1 of Fig. 4 can be completely the same as in the corresponding 1-chip microcomputer, and the second bonding pads 7 and wirings 9, 12 and 13 are only additives to the masks for the 1-chip microcomputer. Hence, a further efficient use of the chip area can be attained as well as a simplified pattern design and an enhanced reliability of the wirings in the evaluation chip compared to the former embodiment of Fig. 3.

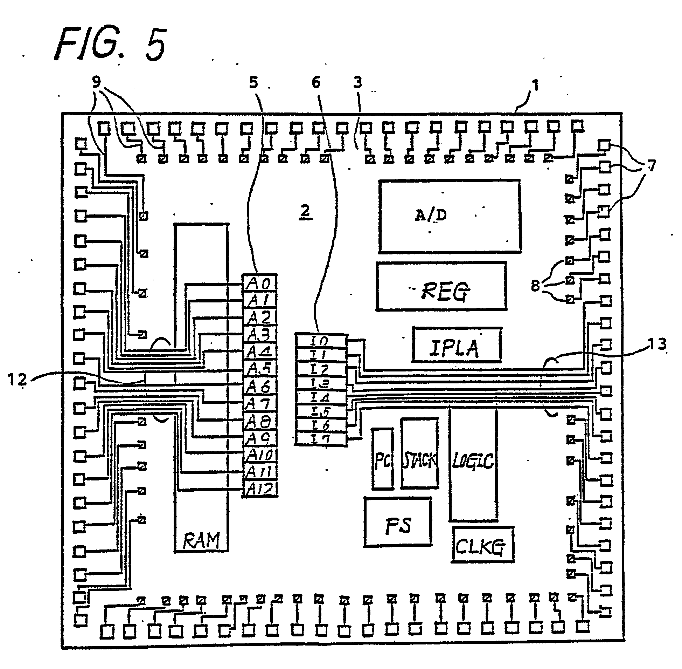

Fig. 5 is a schematic plan view illustrating a further detailed arrangement of patterns formed on an evaluation chip in accordance with a third embodiment of the present invention. In Figs. 4 and 5, the same reference numerals designate like or corresponding parts. Referring to Fig. 5, additional facilities including a random access memory RAM, an analog-to-digital converter A/D, a stack register STACK and a prescaler PS are formed in a not-indicated device area on an evaluation chip 1. The address output buffer 5 comprises elemental circuits $A_0$ to $A_{12}$ and the data input buffer 6 comprises elemental circuits $I_0$ to $I_7$. Each of these elemental circuits is connected to a corresponding one of second bonding pads 7 via a respective one of wirings 12 and 13.

In the fabrication of the evaluation chip of Fig. 4 or 5 using a multiple-layer wiring configuration, it is preferable to add the patterns of the respective internal wirings of the address output buffer 5 and data input bufer 6 to a lower wiring layer which is selected to form therein the internal wirings of the facilities and the first bonding pads 8, and to add patterns of the second bonding pads 7 and wirings 9, 12 and 13, all connected to the second bonding pads 7, to an upper wiring layer which is selected to form therein interconnections between the facilities. In a double-layer wiring configuration, the latter wiring layer is uppermost. When a multiple-layer wiring configuration of three or more layers is employed, it is preferable to use the uppermost wiring layer thereof for forming therein the second bonding pads 7 and the wirings 9, 12 and 13, all connected to the second bonding pads 7.

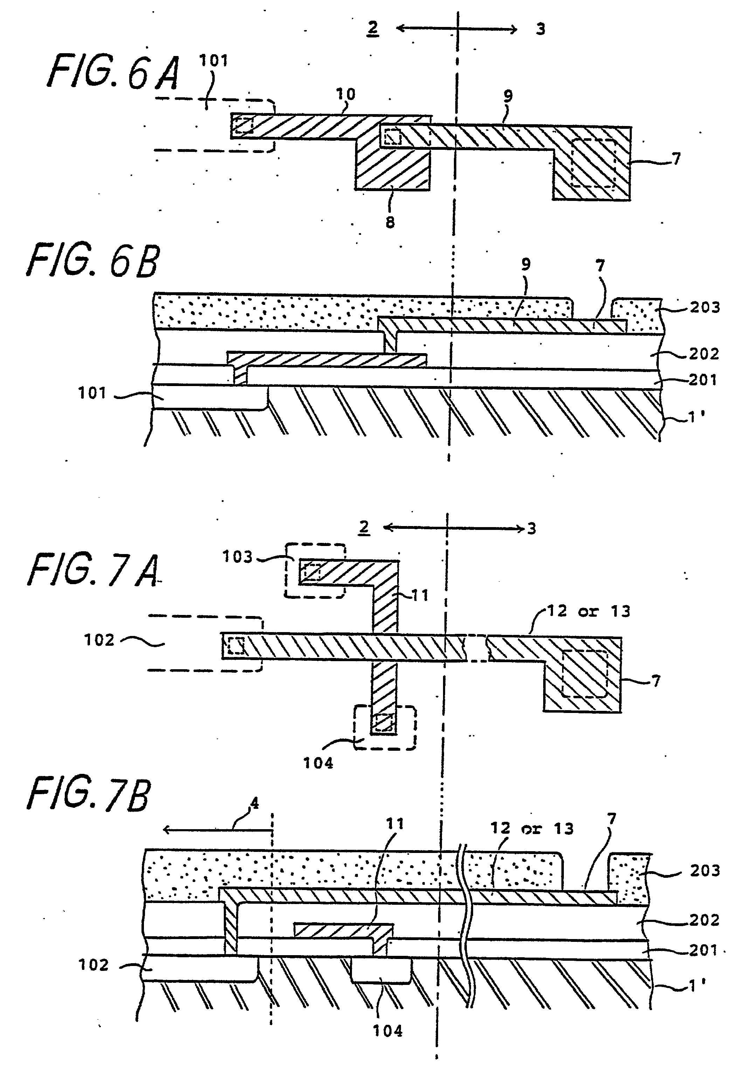

Figs. 6A and 6B are a schematic partial plan view and a cross-section of an evaluation chip fabricated according to the second or third embodiment, illustrating first and second bonding pads and wir-

4

ings connected thereto, which are formed by using a double-layer wiring configuration. The first bonding pad 8 and a wiring 10 connecting a diffusion region 101 to the first bonding pad 8 are formed from the lower layer of the double-layer wiring configuration. The diffusion region 101 formed in a semiconductor substrate 1' which constitutes the evaluation chip is a part of one of the facilities formed in the device area 2. The second bonding pad 7 formed at the extended area 3 of the evaluation chip and a wiring 9 interconnecting the first bonding pad 8 and the second bonding pad 7 are formed from the upper layer of the double-layer wiring configuration. The lower wiring layer is isolated from the substrate 1' by a dielectric layer 201. Another dialectric layer 202 is formed to isolate the lower and upper wiring layers from each other. The bonding pad 7 can be provide with an external connection through a window formed in a passivation layer 203.

Figs. 7A and 7B are a schematic partial plan view and a cross-section of an evaluation chip fabricated according to the second or third embodiment, illustrating a second bonding pad and two wirings formed by using a double-layer wiring configuration. In Figs 7A and 7B, the second bonding pad 7 formed in the extended area 3 of the evaluation chip is connected to a diffusion layer 102 formed in the device area 2 via a wiring 12 (13). The diffusion region 102 which is formed in a semiconductor substrate 1' constituting the evaluation chip is a part of a buffer circuit formed in the ROM region 4. The second bonding pad 7 and wiring 12 (13) are formed from the upper layer of the double-layer wiring configuration. The wiring 12 (13) intersects another wiring 11 formed from the lower layer of the double-layer wiring configuration. The wiring 11 is designed for interconnecting diffusion regions 103 and 104, each of which constitutes a part of a respective facility formed in the device area 2. In the cross-section of Fig. 7B, the illustration of the diffusion region 104 and wiring 11 is not correct in the strict sense but intended for facilitating the understanding. The wiring 11 is isolated from the substrate 1' by a dielectric layer 201. The wirings 11 and 12 (13) are insulated from each other by another dielectric layer 202. The second bonding pad 7 can be provided with an external connection through a window formed in a passivation layer 203. Thus, the respective wirings 12 and 13 for connecting the buffers 5 and 6 to the second bonding pads 7 in Fig. 4 or 5 can be distributed without causing a need for re-arranging the facilities in the device area.

As described above, the method according to the present invention allows elimination of the need for modifications in the arrangement of the facilities and in the pattern of wirings interconnecting same, which are designed for the mass-production of a 1-chip microcomputer, when an evaluation chip is fabricated based on the mask patterns designed for the mass-production chips, hence, simplifies the wirings for the external connections thereof and minimizes erroneous wirings in the evaluation chip. The productivity and reliability in the fabrication of the evaluation chip are thereby enhanced. Further, the above together with the forming of the interface means for the external memory device in the ROM region permits the increase of efficiency of area utilization in both of the mass-production and evaluation chips.

## Claims

1. A method for fabricating a 1-chip microcomputer, comprising the steps of:
   (a) producing a first set of masks which are used for mass-producing chips of the 1-chip microcomputer, each of the masks having regions in which patterns for forming pluralities of first bonding pads, a ROM and other facilities are provided, the first bonding pads being arranged in an array surrounding the other facilities;
   (b) fabricating a chip of the 1-chip microcomputer by using the first set of masks;
   (c) producing a second set of masks for an evaluation chip, said evaluation chip being used for evaluating a program to be held in the ROM of each mass-production chip, said production of the second set of masks comprising the steps of:
   - replacing the patterns for the ROM region in each of the first set of masks by corresponding patterns for forming interface means for allowing the evaluation chip to have an access to an external memory device; and
   - adding to the first set of masks patterns for forming second bonding pads and connection wirings between the second bonding pads and the first bonding pads and the interface means, the second bonding pads being arranged in an array surrounding the array of the first bonding pads; and
   (d) fabricating an evaluation chip by using the second set of masks.

2. A method according to claim 1, wherein the interface means includes an address output buffer for transmitting address signals to the external memory device and a data input buffer for receiving data signals from the external memory device, the address output and data input buffers being connected to the second bonding pads.

3. A method as claimed in any one of claims 1 and 2, wherein said evaluation chip further comprises multiple wiring layers, and wherein the second bonding pads and corresponding wirings connected thereto are formed in the uppermost wiring layer and the remainder wirings are formed in a lower wiring layer.

4. A method as claimed in any one of claims 1 to 3, wherein the second bonding pads and corresponding wirings connected thereto are formed in the masks for forming the first bonding pads.

5. A method as claimed in claim 2, wherein the respective pluralities of the second bonding pads connected to the address input and data output buffers are arranged to form respective groups at the periphery of the evaluation chip.

6. A method as claimed in any one of claims 1 and 2, wherein the evaluation chip is provided with an extended area around an area equivalent to the mass-production chip for forming therein the second bonding pads.

## Patentansprüche

1. Verfahren zur Herstellung eines 1-Chipmicrocomputers mit den folgenden Schritten:

(a) Herstellen eines ersten Satzes von Masken, welche zur Massenproduktion von Chips des 1-Chipmicrocomputers verwendet werden, wobei jede Maske Bereiche hat, in denen Muster zur Bildung eines Vielzahl von ersten Verbindungsfeldern, ein ROM und andere Einrichtungen vorgesehen sind, von denen die ersten Verbindungsfelder in einer Gruppierung angeordnet sind, die die anderen Einrichtungen umgibt;

(b) Herstellen eines Chip des 1-Chipmicrocomputers unter Verwendung des ersten Satzes von Masken;

(c) Herstellen eines zweiten Satzes von Masken für ein Auswertungschip, welches Auswertungschip zum Auswerten eines Programmes verwendet wird, das in dem ROM von jedem Massenproduktionschip gehalten werden soll, wobei die genannte Produktion des zweiten Satzes von Masken die folgenden Schritte umfaßt:

– Ersetzen der Muster für den ROM-Bereich in jedem des ersten Satzes von Masken durch entsprechende Muster zum Bilden von Schnittstelleneinrichtungen, um zu ermöglichen, daß das Auswertungschip einen Zugriff zu einer externen Speichervorrichtung hat; und

– Hinzufügen, zu dem ersten Satz von Masken, von Mustern, zur Bildung von zweiten Verbindungsfeldern und Verbindungsverdrahtungen zwischen den zweiten Verbindungsfeldern und den ersten Verbindungsfeldern und den Schnittstelleneinrichtungen, wobei die zweiten Verbindungsfelder in einer Gruppierung angeordnet sind, welche die Gruppierung der ersten Verbindungsfelder umgibt; und

(d) Herstellen eines Auswertungschips durch Verwendung des genannten zweiten Satzes von Masken.

2. Verfahren nach Anspruch 1, bei dem die Schnittstelleneinrichtung einen Adreßausgangspuffer zum Übertragen von Adreßsignalen an die externe Speichervorrichtung umfaßt, und einen Dateneingangspuffer zum Empfangen von Datensignalen von der externen Speichervorrichtung, wobei die Adreßausgangs- und die Dateneingangspuffer mit den zweiten Verbindungsfeldern verbunden sind.

3. Verfahren nach einem der Ansprüche 1 und 2, bei dem das genannte Auswertungschip ferner mehrfache Verdrahtungsschichten umfaßt, und bei dem die zweiten Verbindungsfelder und entsprechende Verdrahtungen, die damit verbunden sind, in der obersten Verdrahtungsschicht geformt werden und die restlichen Verdrahtungen in einer unterne Verdrahtungsschicht geformt werden.

4. Verfahren nach einem der Ansprüche 1 bis 3, bei dem die zweiten Verbindungsfelder und die entsprechenden Verdrahtungen, die damit verbunden sind, in den Masken zur Bildung der ersten Verbindungsfelder geformt werden.

5. Verfahren nach Anspruch 2, bei dem die entsprechenden Vielzahlen von zweiten Verbindungsfeldern, die mit den Adreßeingangs- und Datenausgangspuffer verbunden sind, so angeordnet sind, daß sie jeweils Gruppen bei dem Umfang des Auswertungschips bilden.

6. Verfahren nach einem der Ansprüche 1 und 2, bei dem das Auswertungschip mit einem erstreckten Bereich um einen Bereich versehen ist, der dem Massenproduktionschip equivalent ist, um darin zweite Verbindungsfelder zu bilden.

## Revendications

1. Procédé de fabrication d'un micro-ordinateur à une seule puce, comprenant les opérations suivantes :

(a) produire un premier ensemble de masques qui sont utilisés pour produire en série des puces du micro-ordinateur à une seule puce, chacun des masques possédant des régions dans lesquelles sont prévus des motifs destinés à former plusieurs premiers plots d'interconnexion, une ROM et d'autres éléments d'équipement, les premiers plots d'interconnexion étant disposés dans un réseau entourant les autres éléments d'équipement;

(b) fabriquer une puce du micro-ordinateur à une seule puce en utilisant le premier ensemble de masques ;

(c) produire un deuxième ensemble de masques destinés à une puce d'évaluation, ladite puce d'évaluation étant utilisée pour évaluer un programme devant être contenu dans la ROM de chaque puce produite en série, la production du deuxième ensemble de masques comprenant les opérations suivantes :

- remplacer les motifs de la région ROM de chaque masque du premier ensemble de masques par des motifs correspondants destinés à former un moyen d'interface permettant que la puce d'évaluation ait accès à un dispositif externe de mémorisation ; et

- ajouter audit premier ensemble de masques des motifs destinés à former des deuxièmes plots d'interconnexion et des câblages de connexion entre les deuxièmes plots d'interconnexion, les premiers plots d'interconnexion et le moyen d'interface, les deuxièmes plots d'interconnexion étant disposés dans un réseau entourant le réseau des premiers plots d'interconnexion ; et

(d) fabriquer une puce d'évaluation en utilisant le deuxième ensemble de masques.

2. Procédé selon la revendication 1, où le moyen d'interface comporte un tampon de sortie d'adresses servant à transmettre des signaux d'adresses au dispositif externe de mémorisation et un tampon d'entrée de données servant à recevoir des signaux de données de la part du dispositif externe de mémorisation, les tampons de sortie d'adresses et d'entrée de données étant connectés aux deuxièmes plots d'interconnexion.

3. Procédé selon l'une quelconque des revendications 1 et 2, où ladite puce d'évaluation comprend en outre des couches de câblage multiples, et où les deuxièmes plots d'interconnexion et les câblages correspondants qui leur sont connectés sont formés dans la couche de câblage supérieure, les câblages restants étant formés dans une couche de câblage inférieure.

4. Procédé selon l'une quelconque des revendications 1 à 3, où les deuxièmes plots d'interconnexion et les câblages correspondants qui leur sont connectés sont formés dans les masques destinés à former les premiers plots d'interconnexion.

5. Procédé selon la revendication 2, où les différents deuxièmes plots d'interconnexion respectifs qui sont connectés aux tampons d'entrée d'adresses et de sortie de données sont disposés de manière à former des groupes respectifs à la périphérie de la puce d'évaluation.

6. Procédé selon l'une quelconque des revendications 1 et 2, où la puce d'évaluation est dotée d'une surface étendue qui entoure une aire équivalant à la puce à produire en série, afin que les deuxièmes plots d'interconnexion y soient formés.

FIG. 1

FIG. 2 PRIOR ART

# FIG. 3

*FIG. 4*

# FIG. 5

FIG. 6 A

FIG. 6 B

FIG. 7 A

FIG. 7 B